# EUROPÄISCHE PATENTSCHRIFT

(11) **EP 0 700 240 B1**
(45) Veröffentlichungstag und Bekanntmachung des Hinweises auf die Patenterteilung: **18.06.2003**
(21) Anmeldenummer: 95112894.1
(22) Anmeldetag: 17.08.1995
(51) Int. Cl.: H05K 5/00, B60R 16/02, H05K 7/14

(54) **Elektrisches oder elektronisches Gerät für ein Kraftfahrzeug**
Electrical or electronic device for a motor vehicle
Dispositif électrique ou électronique pour un véhicule

(30) Priorität: 24.08.1994 DE 4429984
(43) Veröffentlichungstag der Anmeldung: 06.03.1996
(73) Patentinhaber: Hella KG Hueck & Co., 59552 Lippstadt (DE)
(72) Erfinder: Brües, Heinz, D-59590 Geseke (DE); Winter, Michael, D-59065 Hamm (DE)

(56) Entgegenhaltungen:
- EP-A- 0 101 359
- DE-A- 3 437 988
- DE-A- 4 303 908
- US-A- 5 335 145

## Beschreibung

Die Erfindung betriff ein elektrisches oder elektronisches Gerät für ein Kraftfahrzeug, mit einer zumindest in einem Teilbereich biegsamen Leiterplatte, wobei zwei durch den biegsamen Teilbereich getrennte Abschnitte der Leiterptatte mit gegenüberliegenden Flächen eines im wesentlichen ebenen Tragrahmens verbunden sind.

Eine aus starren und flexiblen Bereichen bestehende Leiterplatte ist aus den Unterlagen des deutschen Gebrauchsmusters 91 16 280.7 bekannt. Hierbei sind die flexiblen Bereiche durch bereichsweisen Materialabtrag von eher starren Leiterplatte gebildet.

Wie im zweiten Absatz auf Seite 2 der Gebrauchsmusterschrift angeführt ist, eignet sich eine solche Leiterplatte für Anwendungen, bei denen der flexible Bereich nur zahlenmäßig begrenzten und relativ kleinen Biegebeanspruchungen ausgesetzt ist.

Insbesondere bei elektrischen oder elektronischen Geräten, die in Kraftfahrzeugen eingesetzt werden, ist eine solche Leiterplatte auch nach der Montage noch andauernden mechanischen Belastungen ausgesetzt, die durch die Fahrzeugbewegungen und Schwingungen der Fahrzeugkarosserie entstehen. Hierdurch besteht die Gefahr, daß längerfristig der Biegebereich der Leiterplatte beschädigt wird. Da im allgemeinen auch Leiterbahnen über den Biegebereich geführt werden, kann dieses zum Ausfall des elektrischen oder elektronischen Gerätes führen.

Aus der DE 43 03 908 A1 ist ein Gehäuse eines elektrischen oder elektronischen Steuergerätes für ein Kraftfahrzeug bekannt, mit einer zumindest in einem Teilbereich biegsamem Leiterplatte, wobei zwei durch den Teilbereich getrennte Abschnitte der Leiterplatte mit gegenüberliegenden Flächen eines im wesentlichen ebenen Tragrahmens durch Rastmittel verbunden sind.

Es stellte sich die Aufgabe, ein elektrisches oder elektronisches Gerät mit einer zumindest in Teilbereichen biegsamen Leiterplatte so auszubilden, daß die Leiterplatte besonders gut vor Beschädigungen durch mechanische Einwirkungen geschützt ist. Weiter soll, mit Rücksicht auf die beschränkten Platzverhältnisse in Kraftfahrzeugen, die Anordnung der Leiterplatte möglichst kompakt ausgeführt werden.

Im Hinblick auf die Massenfertigung soll dabei das elektrische oder elektronische Gerät möglichst kostengünstig sein, was durch einen möglichst geringen Aufwand bezüglich Bauteile und Montage erreicht werden soll.

Diese Aufgabe wird erfindungsgemäß dadurch gelöst, daß der Tragrahmen als Rastmittel einen als einarmigen Hebel ausgebildeten Torsionsschnapphaken aufweist, der in eine Ausnehmung der Leiterplatte eingreift und daß der Tragrahmen federale Elemente aufweist, die einen Abschnitt der Leiterplatte gegen die Unterkante des Torsionsschnapphakens drücken.

Der im wesentlichen ebene Tragrahmen ermöglicht hierbei vorteilhafterweise, die beiden Abschnitte der Leiterplatte in geringem Abstand paralel zueinander anzuordnen, und somit eine besonders kleinbauende Anordnung zu schaffen.

Der Tragrahmen ist ein relativ einfach aufgebautes Bauteil und als kostengünstiges Kunststoffspritzteil herstellbar.

Die Rastmittel, die am Tragekörper angeordnet sind und am Rand oder in Ausnehmungen der Leiterplatte eingreifen, ermöglichen eine einfache und kostengünstige Montage der Leiterplatte an dem Tragekörper.

Weiterhin ist vorteilhaft, daß die Rastmittel keine allzu starre Verbindung zwischen Leiterplatte und Tragrahmen herstellen. Hierdurch wird vermieden, daß mechanische Spannungen innerhalb der Leiterplatte auftreten, die das Auftreten von Beschädigungen im Biegebereich der Leiterplatte bewirken oder begünstigen.

Die besonders einfache und sichere Verbindung der Leiterplatte mit dem Tragrahmen wird durch einen Torsionsschnapphaken erreicht, der in eine Ausnehmung der Leiterplatte eingreift. Da eine kleine Bauhöhe des Tragrahmens gewünscht ist, ist der Torsionsschnapphaken vorteilhafterweise als einarmiger Hebel ausgebildet.

Um ein sicheres Einrasten des Torsionsschnapphakens in die Ausnehmung der Leiterplatte zu gewährleisten, muß dessen Höhe gegenüber der Dicke der Leiterplatte etwas Spiel aufweisen. Um eine klapperfreie Verbindung zwischen Leiterplatte und Tragrahmen zu erzielen, sind am Tragrahmen federnde Elemente angeordnet, welche die Leiterplatte unter leichter mechanischer Spannung gegen die Unterkante des Torsionsschnapphakens drücken.

Weitere vorteilhafte Weiterbildungen und Ausgestaltungen eines erfindungsgemäßen elektrischen oder elektronischen Gerätes gehen aus den Unteransprüchen hervor.

So ist es vorteilhaft, wenn der Tragrahmen Biegekanten aufweist. Hierdurch wird verhindert, daß beim Verbinden von Tragrahmen und Leiterplatte, der Biegeradius der biegsamen Bereiche der Leiterplatte unterschritten oder überschritten wird und so der Biegebereich der Leiterplatte beschädigt wird.

In diesem Zusammenhang ist es ebenfalls vorteilhaft, wenn die Höhe des Tragrahmens etwa dem doppelten Biegeradius entspricht, da hierdurch die auf dem Tragrahmen angeordnete Leiterplatte im Biegebereich eine Biegung mit dem empfohlenen Biegeradius aufweist.

Der Tragrahmen braucht keinesfalls aus einer massiven Platte zu bestehen. Im Gegenteil ist es zur Gewichts- und Materialersparung wesentlich günstiger, den Tragrahmen durch im Umfangsbereich angeordnete Kunststoffstege auszubilden. Um eine ausreichende Stabilität des Tragrahmens zu gewährleisten, ist es weiter vorteilhaft, die den Umfangsbereich des Tragrahmens ausbildenden Stege durch weitere Stege miteinander zu verbinden.

Ein zusätzlicher Vorteil hierbei ist, daß diese weiteren Stege ein flächiges Element inmitten des Tragrahmens halten können, an welchem verschiedene Elemente des Tragrahmens angeformt sind, wie z.B. die federnden Elemente, der Torsionsschnapphaken oder auch ein Zentrierzapfen, der die Lage der Leiterplatte bezüglich des Tragrahmens festlegt.

Ebenfalls vorteilhaft ist es, wenn der Tragrahmen senkrecht zu seiner Rahmenfläche verlaufende Stützen aufweist, die nach dem Zusammenfügen des Gehäuses unter federnder Spannung gehalten werden. Die Stützen erzielen hierdurch eine stoßdämpfende Wirkung, wodurch mechanische Einwirkungen (Schwingungen, Stöße) auf das Gehäuse in ihrer Wirkung auf die aus Leiterplatte und Tragrahmen bestehende Anordnung abgeschwächt werden.

Im folgenden soll ein Ausführungsbeispiel eines erfindungsgemäßen elektrischen oder elektronischen Gerätes anhand der Zeichnung näher erläutert werden.

Es zeigen
- Figur 1: einen zum erfindungsgemäßen elektrischen oder elektronischen Gerät gehörenden Tragrahmen;
- Figur 2 und 3: das erfindungsgemäße elektrische oder elektronische Gerät während zweier Phasen der Montage (teilweise im Schnitt);
- Figur 4: einen Detailausschnitt des erfindungsgemäßen elektrischen oder elektronischen Gerätes.

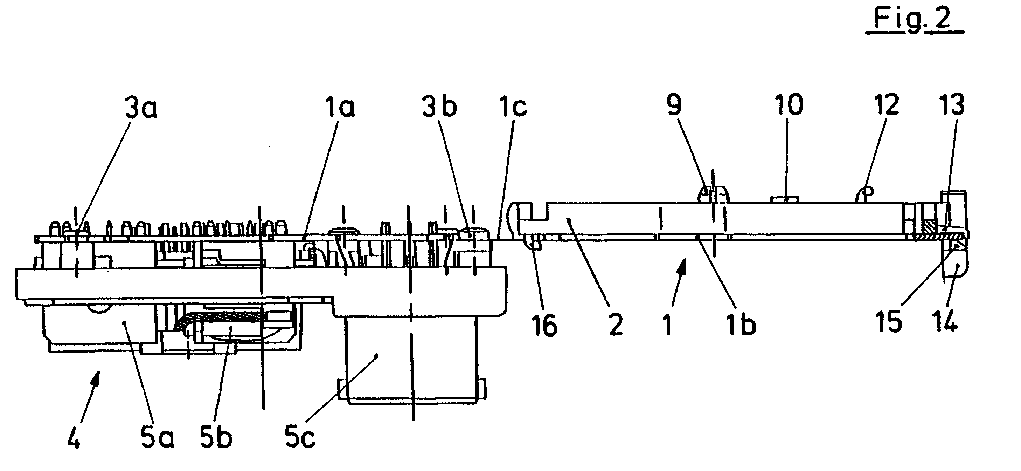

Figur 2 zeigt die aus zwei starren Abschnitten (1a, 1b) und einem biegsamen Bereich (1c) bestehende Leiterplatte (1). Der erste Abschnitt (1a) der Leiterplatte (1) ist mittels mehrerer Schraubverbindungen (3a, 3b) mit einem Gehäuseteil (4) verbunden.

In den Bereich des Gehäuseteils (4) erstrecken sich elektrische und elektromechanische Baugruppen (5a, 5b, 5c), deren Anschlußkontakte mit dem ersten Abschnitt (1a) der Leiterplatte (1) verlötet sind. Die Baugruppen (5a, 5b) sind hier beispielhaft als Relais ausgeführt; die Baugruppe (5c) bildet einen Anschlußstecker aus, der mit dem Gehäuseteil (4) eine Baueinheit bildet.

Um die Zeichnung übersichtlich zu gestalten, wurde auf die Darstellung weiterer auf der Leiterplatte (1) angeordneter elektrischer und elektronischer Bauteile verzichtet.

Die Leiterplatte (1) weist weiterhin einen vergleichsweise schmalen biegsamen Bereich (1c) auf, der den ersten und zweiten Abschnitt (1a, 1b) der Leiterplatte (1) miteinander verbindet.

Auf dem zweiten Abschnitt (1b) der Leiterplatte (1) ist ein Tragrahmen (2) aufgesetzt und mechanisch mit diesem verbunden.

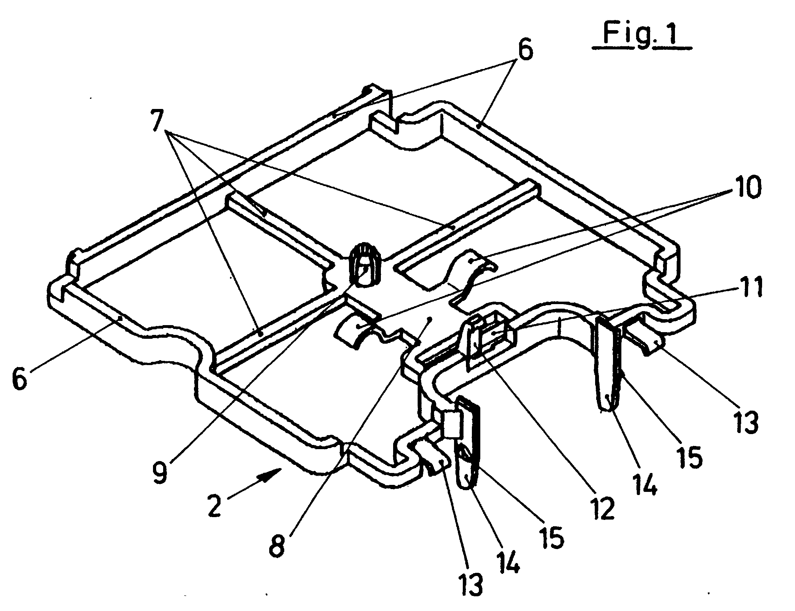

Die Ausgestaltung des Tragrahmens (2) ist deutlicher in der Figur 1 erkennbar, die den Tragrahmen (2) aus einer anderen Perspektive (Draufsicht schräg von oben) darstellt.

Der Umfangsbereich des Tragrahmens (2) wird durch Kunststoffstege (6) gebildet, wobei die Formgebung dieser Kunststoffstege (6) etwa der Außenkontur der Leiterplattenabschnitte entspricht. Die Kunststoffstege (6) sind im Inneren des Tragrahmens (2) durch mehrere weitere Stege (7) miteinander verbunden, die so den Tragrahmen (2) mechanisch stabilisieren. Etwa in der Mitte des Tragrahmens (2) treffen sich diese weiteren Stege (7) und bilden ein flächiges Element (8) aus, an welchem ein Zentrierzapfen (9) und zwei federnde Elemente (10) angeformt sind.

Im vorderen Bereich gabelt sich das flächige Element (8), wobei innerhalb der Gabelung ein zylindrischer Steg (11) angeformt ist, von dem aus sich ein als einarmiger Hebel ausgebildeter Torsionsschnapphaken (12) senkrecht zur Tragrahmenebene erstreckt.

An die Kunststoffstege (6) des Tragrahmens (2) sind zwei Rasthaken (13) sowie zwei Stützen (14) angeformt. Die Stützen (14) weisen an einer Außenseite jeweils eine Führung (15) auf.

In der Figur 1 nicht erkennbar sind zwei Anschlaghaken, die an dem Tragrahmen (2) im hinteren Bereich an der Unterseite der Kunststoffstege (6) angeformt sind.

In der Darstellung der Figur 2 ist einer dieser Anschlaghaken (16) erkennbar. Der Anschlaghaken (16) hintergreift eine Außenkante des Abschnittes (1b) der Leiterplatte (1). Zusammen mit den Rasthaken (13) sichern die Anschlaghaken (16) den Tragrahmen (2) gegen eine Verschiebung parallel zum Leiterplattenabschnitt (1b). Die Führungen (15) der Stützen (14), welche in Freimachungen des Abschnittes (1b) der Leiterplatte (1) eintauchen, sichern den Tragrahmen (2) gegen eine Bewegung senkrecht zum Leiterplattenabschnitt (1b). Zur Verdeutlichung zeigt der umrandete Bereich der Figur 2 die Anordnung aus Leiterplattenabschnitt (1b), einem Rasthaken (13) und eine Führung (15) in einem Teilschnitt.

Weiterhin sind in der Figur 2 Teile des Zentrierzapfens (9), der federnden Elemente (10) und des Torsionsschnapphakens (12) erkennbar.

In dem Montageschritt, welcher der in der Figur 2 dargestellten Montagephase folgt, biegt nun eine nicht dargestellte Vorrichtung den Abschnitt (1b) der Leiterplatte (1) mit samt dem auf dem Abschnitt (1b) befestigten Tragrahmen (2) parallel zum Abschnitt (1a) der Leiterplatte (1).

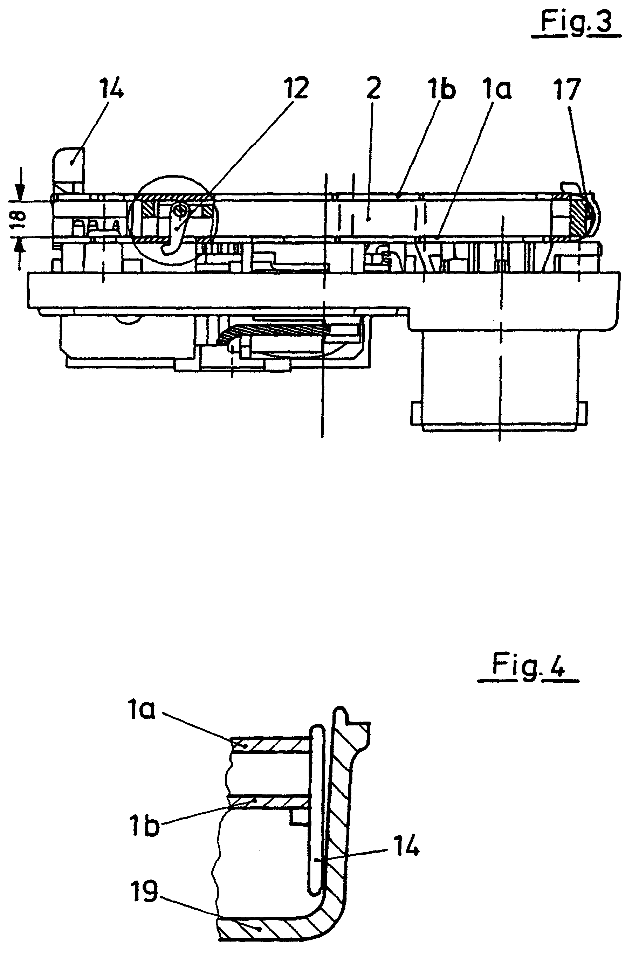

Nach Abschluß dieses Montageschritts weist das erfindungsgemäße elektrische oder elektronische Gerät die in der Figur 3 dargestellte Anordnung auf.

Wie der umrandete Schnittbereich der Figur 3 zeigt, rastet der Torsionsschnapphaken (12) in eine Ausnehmung des Leiterplattenabschnitts (1a) und erzielt so eine sichere mechanische Verbindung von Leiterplattenabschnitt (1a), Tragrahmen (2) und Leiterplattenabschnitt (1b).

Die Positionierung des Tragrahmens (2) auf dem Leiterplattenabschnitt (1a) wird durch den in der Figur 3 nicht dargestellten Zentrierzapfen (9) unterstützt, der in eine Ausnehmung des Leiterplattenabschnittes (1a) eingreift.

Der Torsionsschnapphaken (12) ist in diesem Ausführungsbeispiel aufgrund der beengten Platzverhältnisse bei dem dargestellten Gerät besonders kleinbauend und daher platzsparend ausgebildet. Aufgrund seiner kurzen Bauart weist der abgebildete Abschnitt des Torsionsschnapphakens (12) im oberen Bereich keine ausreichende Schräge auf, um ein selbsttätiges Verrasten mit dem Leiterplattenabschnitt (1a) zu ermöglichen. Ein solcher kurzer Torsionsschnapphaken (12) wird daher durch die die Biegung der Leiterplatte (1) ausführenden Vorrichtungen vorgespannt, so daß auf einfache Weise ein Einrasten des Torsionsschnapphakens in die Ausnehmung des Leiterplattenabschnittes (1a) möglich wird.

Eine wichtige Funktion erfüllen die (in der Figur 3 nicht dargestellten) federnden Elemente. Um ein sicheres Verrasten des Torsionsschnapphakens (12) und des Leiterplattenabschnittes (1a) zu gewährleisten, müssen deren Abmessungen Toleranzen aufweisen, die nach dem Verrasten zu Spiel zwischen dem Torsionsschnapphaken (12) und dem Leiterplattenabschnitt (1a) führen können. Die Anordnung kann dadurch "klappern", was zu einer mechanischen Belastung des biegsamen Bereiches (1c) der Leiterplatte (1) führt. Die federnden Elemente verhindern dieses, indem sie den Leiterplattenabschnitt (1a) federnd gegen die Unterkante des Torsionsschnapphakens (12) drücken.

Der biegsame Bereich (1c) der Leiterplatte (1) liegt an Biegekanten (17) an. Diese Biegekanten (17) unterstützen bei der Montage den Biegevorgang, indem sie ein Biegen des Bereiches (1c) der Leiterplatte (1) mit einem zu kleinen oder zu großen Biegeradius, und damit eine hieraus resultierende Beschädigung des biegsamen Bereiches (1c) der Leiterplatte verhindern.

Um die mechanische Belastung des biegsamen Teilbereiches (1c) so klein wie möglich zu halten, weist zudem der Tragrahmen (2) eine Höhe (18) auf, die etwa dem doppelten empfohlenen Biegeradius der Leiterplatte (1) entspricht.

Von besonderem Vorteil sind die senkrecht zur Tragrahmenebene verlaufenden Stützen (14), die an den Tragrahmen (2) angeformt sind. Diese Stützen (14) sind elastisch ausgeformt und verringern die Schwingungsfähigkeit des Tragrahmens (2). Die Anordnung einer Stütze im Gerätegehäuse skizziert die Figur 4.

Figur 4 zeigt eine Stütze (14) des Tragrahmens sowie Ausschnitte der mit dem Tragrahmen verbundenen Leiterplattenabschnitte (1a, 1b). Weiterhin ist ein Ausschnitt aus einem zweiten Gehäuseteil (19) dargestellt, welches beim fertig montierten Gerät das in den Figuren 2 und 3 gezeigte Gehäuseteil (4) abschließt. Beim Aufsetzen des zweiten Gehäuseteils (19) auf das erste Gehäuseteil (4) laufen die Stützen (14) entlang des Innenradius des zweiten Gehäuseteils (19) und deformieren sich dabei. Hierdurch steht der Tragrahmen unter Federspannung, wodurch die Schwingungsfähigkeit des Tragrahmens deutlich gesenkt wird. Besonders werden Stöße und Erschütterungen des Gehäuses nur noch stark gedämpft an die Leiterplatte weitergegeben, wodurch insbesondere der empfindliche Biegebereich der Leiterplatte gegen Beschädigung und Zerstörung geschützt wird.

Anzumerken bleibt, daß viele der Vorteile des in diesem Ausführungsbeispiel erläuterten elektrischen oder elektronischen Gerätes, insbesondere im Hinblick auf einfache Montage und besondere mechanische Stabilität, auch beim Einsatz einer durchgängig flexiblen Leiterplatte erzielt werden.

### Bezugszeichenliste

Elektrisches oder elektronisches Gerät für ein Kraftfahrzeug
- 1: Leiterplatte
- 1a: erster (starrer) Abschnitt der Leiterplatte
- 1b: zweiter (starrer) Abschnitt der Leiterplatte
- 1c: biegsamer Bereich der Leiterplatte
- 2: Tragrahmen
- 3a, 3b: Schraubverbindungen
- 4: (erstes) Gehäuseteil
- 5a, 5b, 5c: elektrische und elektromechanische Baugruppen
- 5a, 5b: Relais
- 5c: AnschLußstecker
- 6: Kunststoffstege
- 7: weitere Stege
- 8: flächiges Element
- 9: Zentrierzapfen
- 10: federnde Elemente
- 11: zylindrischer Steg
- 12: Torsionsschnapphaken
- 13: Rasthaken
- 14: Stützen
- 15: Führungen
- 16: Anschlaghaken
- 17: Biegekanten
- 18: Höhe (des Tragrahmens)
- 19: zweites Gehäuseteil (Ausschnitt)

## Patentansprüche

1. Elektrisches oder elektronisches Gerät für ein Kraftfahrzeug, mit einer zumindest in einem Teilbereich (1c) biegsamen Leiterplatte (1), wobei zwei durch den biegsamen Teilbereich (1c) getrennte Abschnitte (1a, 1b) der Leiterplatte (1) mit gegenüberliegenden Flächen eines im wesentlichen ebenen Tragrahmens (2) durch Rastmittel (12,13) verbunden sind,
**dadurch gekennzeichnet,**
**daß** der Tragrahmen (2) als Rastmittel einen als einarmigen Hebel ausgebildeten Torsionsschnapphaken (12) aufweist, der in eine Ausnehmung der Leiterplatte (1) eingreift und daß der Tragrahmen (2) federnde Elemente (10) aufweist, die einen Abschnitt der Leiterplatte (1a) gegen die Unterkante des Torsionsschnapphakens (12) drücken.

2. Elektrisches oder elektronisches Gerät nach Anspruch 1, **dadurch gekennzeichnet, daß** der Tragrahmen (2) abgerundete Biegekanten (17) aufweist.

3. Elektrisches oder elektronisches Gerät nach Anspruch 1, **dadurch gekennzeichnet, daß** der Umfangsbereich des Tragrahmens (2) durch Kunststoffstege (6) ausgebildet wird, die zur Stabilisierung durch weitere Stege (7) miteinander verbunden sind.

4. Elektrisches oder elektronisches Gerät nach Anspruch 3, **dadurch gekennzeichnet, daß** die weiteren Stege (7) mit einem flächigen Element (8) inmitten des Tragrahmens (2) verbunden sind, an welchem die federnden Elemente (10) angeformt sind.

5. Elektrisches oder elektronisches Gerät nach Anspruch 4, **dadurch gekennzeichnet, daß** auf dem flächigen Element (8) ein Zentrierzapfen (9) angeformt ist, der in eine Ausnehmung der Leiterplatte (1) hineinragt.

6. Elektrisches oder elektronisches Gerät nach Anspruch 1, **dadurch gekennzeichnet, daß** der Tragrahmen (2) senkrecht zur Rahmenfläche verlaufende Stützen (14) aufweist, die durch ein Gehäuseteil (19) unter federnder Spannung gehalten werden.

7. Elektrisches oder elektronisches Gerät nach Anspruch 1, **dadurch gekennzeichnet, daß** der Tragrahmen (2) als einstückiges Kunststoffspritzteil ausgebildet ist.

8. Elektrisches oder elektronisches Gerät nach Anspruch 1, **dadurch gekennzeichnet, daß** die Höhe (18) des Tragrahmens (2) etwa dem doppelten Biegeradius des biegsamen Bereiches (1c) der Leiterplatte (1) entspricht.

## Claims

1. Electrical or electronic device for a motor vehicle, with a printed circuit board (1) flexible at least in a partial zone (1c), wherein two portions (1a, 1b) of the printed circuit board (1) separated by the flexible partial zone (1c) are connected by catch means (12, 13) to opposing faces of a substantially flat support frame (2),
**characterized in that**
the support frame (2) possesses as catch means a torsion snap hook (12) configured as a single-armed lever which engages into a recess in the printed circuit board (1) and **in that** the support frame (2) has elastic elements (10) which press a portion of the printed circuit board (1a) against the lower edge of the torsion snap hook (12).

2. Electrical or electronic device according to Claim 1, **characterized in that** the support frame (2) has rounded bending edges (17).

3. Electrical or electronic device according to Claim 1, **characterized in that** the peripheral region of the support frame (2) is formed by webs (6) of plastic material which are interconnected by further webs (7) for greater stability.

4. Electrical or electronic device according to Claim 3, **characterized in that** the further webs (7) are joined at the middle of the support frame (2) to a flat element (8) on which the elastic elements (10) are formed.

5. Electrical or electronic device according to Claim 4, **characterized in that** a locating peg (9) which projects into a recess in the printed circuit board (1) is formed on the flat element (8).

6. Electrical or electronic device according to Claim 1, **characterized in that** the support frame (2) has rests (14) perpendicular to the frame surface which are kept under elastic tension by a casing part (19).

7. Electrical or electronic device according to Claim 1, **characterized in that** the support frame (2) is configured as a one-piece plastic injection moulding.

8. Electrical or electronic device according to Claim 1, **characterized in that** the height (18) of the support frame (2) is approximately equal to twice the bending radius of the flexible zone (1c) of the printed circuit board (1).

## Revendications

1. Appareil électrique ou électronique pour un véhicule, équipé d'une plaquette de circuit imprimé (1) flexible au moins partiellement (1c), deux tronçons (1a, 1b) de la plaquette de circuit imprimé (1) séparés par la partie flexible (1c) étant réunis à des surfaces en vis-à-vis d'un cadre porteur (2) sensiblement plan par des moyens d'arrêt (12, 13),
**caractérisé**
**en ce que** le cadre porteur (2) présente en tant que moyens d'arrêt un crochet à déclic à torsion (12) réalisé sous la forme d'un levier à un bras, qui pénètre dans un évidement de la plaquette de circuit imprimé (1) et en ce que le cadre porteur (2) présente des éléments élastiques (10) qui poussent un tronçon (1a) de la plaquette de circuit imprimé contre le bord inférieur du crochet à déclic à torsion (12).

2. Appareil électrique ou électronique selon la revendication 1, **caractérisé en ce que** le cadre porteur (2) présente des bords de flexion arrondis (17).

3. Appareil électrique ou électronique selon la revendication 1, **caractérisé en ce que** la périphérie du cadre porteur (2) est formée par des barrettes de matière plastique (6) qui sont réunies les unes aux autres en vue de la stabilisation par d'autres barrettes (7).

4. Appareil électrique ou électronique selon la revendication 3, **caractérisé en ce que** les autres barrettes (7) sont reliées au milieu du cadre porteur (2) avec un élément plat (8), sur lequel sont formés les éléments élastiques (10).

5. Appareil électrique ou électronique selon la revendication 4, **caractérisé en ce que** sur l'élément plat (8) est formé un pivot de centrage (9) qui pénètre dans un évidement de la plaquette de circuit imprimé (1).

6. Appareil électrique ou électronique selon la revendication 1, **caractérisé en ce que** le cadre porteur (2) présente des montants (14) s'étendant perpendiculairement à la surface du cadre, qui sont maintenus par une partie de boîtier (19) sous une tension élastique.

7. Appareil électrique ou électronique selon la revendication 1, **caractérisé en ce que** le cadre porteur (2) est réalisé sous la forme d'une pièce injectée de matière plastique monolithique.

8. Appareil électrique ou électronique selon la revendication 1, **caractérisé en ce que** la hauteur (18) du cadre porteur (2) correspond à peu près au double du rayon de courbure du tronçon flexible (1c) de la plaquette de circuit imprimé (1).
